# EUROPÄISCHE PATENTSCHRIFT

(11) **EP 3 224 464 B1**
(45) Veröffentlichungstag und Bekanntmachung des Hinweises auf die Patenterteilung: **14.08.2019**
(21) Anmeldenummer: 15797108.6
(22) Anmeldetag: 19.11.2015
(51) Int. Cl.: F02D 41/14, F02D 41/24

(54) **VERFAHREN ZUR ERKENNUNG EINES SPANNUNGSOFFSETS ZUMINDEST IN EINEM BEREICH BEI EINER SPANNUNGS-LAMBDA-KENNLINIE**
METHOD FOR DETECTING A VOLTAGE OFFSET AT LEAST IN A PORTION OF A VOLTAGE LAMBDA CHARACTERISTIC CURVE
PROCÉDÉ DE DÉTECTION D'UN ÉCART DE TENSION AU MOINS DANS UNE PLAGE D'UNE COURBE CARACTÉRISTIQUE DE TENSION LAMBDA

(30) Priorität: 24.11.2014 DE 102014223864
(43) Veröffentlichungstag der Anmeldung: 04.10.2017
(73) Patentinhaber: Robert Bosch GmbH, 70442 Stuttgart (DE)
(72) Erfinder: FEY, Michael, 75446 Wiernsheim (DE)
(86) Internationale Anmeldenummer: PCT/EP2015/077089
(87) Internationale Veröffentlichungsnummer: WO 2016/083232

(56) Entgegenhaltungen:
- EP-A2- 1 088 978
- DE-A1- 19 860 463
- DE-A1-102012 211 683
- DE-A1-102012 211 687
- FR-A1- 2 877 400
- US-A1- 2011 040 472
- US-A1- 2012 116 654
- US-A1- 2014 311 459

## Beschreibung

### Stand der Technik

Aus dem Stand der Technik ist eine Vielzahl von Sensorelementen und Verfahren zur Erfassung mindestens einer Eigenschaft eines Messgases in einem Messgasraum bekannt. Dabei kann es sich grundsätzlich um beliebige physikalische und/oder chemische Eigenschaften des Messgases handeln, wobei eine oder mehrere Eigenschaften erfasst werden können. Die Erfindung wird im Folgenden insbesondere unter Bezugnahme auf eine qualitative und/oder quantitative Erfassung eines Anteils einer Gaskomponente des Messgases beschrieben, insbesondere unter Bezugnahme auf eine Erfassung eines Sauerstoffanteils in dem Messgasteil. Der Sauerstoffanteil kann beispielsweise in Form eines Partialdrucks und/oder in Form eines Prozentsatzes erfasst werden. Alternativ oder zusätzlich sind jedoch auch andere Eigenschaften des Messgases erfassbar, wie beispielsweise die Temperatur.

Beispielsweise können derartige Sensorelemente als so genannte Lambdasonden ausgestaltet sein, wie sie beispielsweise aus Konrad Reif (Hrsg.): Sensoren im Kraftfahrzeug, 1. Auflage 2010, S. 160-165, bekannt sind. Mit Breitbandlambdasonden, insbesondere mit planaren Breitbandlambdasonden, kann beispielsweise die Sauerstoffkonzentration im Abgas in einem großen Bereich bestimmt und damit auf das Luft-/Kraftstoffverhältnis im Brennraum geschlossen werden. Die Luftzahl λ beschreibt dieses Luft-/Kraftstoffverhältnis.

Aus dem Stand der Technik sind insbesondere keramische Sensorelemente bekannt, welche auf der Verwendung von elektrolytischen Eigenschaften bestimmter Festkörper basieren, also auf Ionen leitenden Eigenschaften dieser Festkörper. Insbesondere kann es sich bei diesen Festkörpern um keramische Festelektrolyte handeln, wie beispielsweise Zirkoniumdioxid (ZrO₂), insbesondere yttriumstabilisiertes Zirkoniumdioxid (YSZ) und scandiumdotiertes Zirkoniumdioxid (ScSZ), die geringe Zusätze an Aluminiumoxid (Al₂O₃) und/oder Siliziumoxid (SiO₂ enthalten können.

Zur Optimierung des Schadstoffausstoßes und der Abgasnachbehandlung werden bei modernen Brennkraftmaschinen Lambdasonden zur Bestimmung der Zusammensetzung des Abgases und zur Steuerung der Brennkraftmaschine eingesetzt. Lambdasonden bestimmen den Sauerstoffgehalt des Abgases, was zur Regelung des der Brennkraftmaschine zugeführten Luft-/Kraftstoffgemischs und somit des Abgaslambdas vor einem Katalysator verwendet wird. Dabei wird über einen Lambdaregelkreis die Luft- und Kraftstoffzuführung der Brennkraftmaschine derart geregelt, dass eine für die Abgasnachbehandlung durch in dem Abgaskanal der Brennkraftmaschine vorgesehene Katalysatoren optimale Zusammensetzung des Abgases erreicht wird. Bei Ottomotoren wird in der Regel auf ein Lambda von 1, also ein stöchiometrisches Verhältnis von Luft zu Kraftstoff, geregelt. Die Schadstoffemission der Brennkraftmaschine kann so minimiert werden.

Es sind verschiedene Formen von Lambdasonden im Einsatz. Eine Breitbandlambdasonde, auch als stetige oder lineare Lambdasonde bezeichnet, ermöglicht die Messung des Lambdawertes in dem Abgas in einem weiten Bereich um Lambda = 1 herum. Damit kann beispielsweise eine Brennkraftmaschine auch auf einen mageren Betrieb mit Luftüberschuss geregelt werden.

Durch eine Linearisierung der Sondenkennlinie ist auch mit einer kostengünstigeren Zweipunktlambdasonde eine stetige Lambdaregelung vor Katalysator möglich, wenn auch in einem eingeschränkten Lambdabereich. Bei einer derartigen Zweipunktlambdasonde, auch als Sprungsonde oder Nernstsonde bezeichnet, weist die Spannungs-Lambda-Kennlinie bei λ = 1 einen sprungartigen Abfall auf. Sie erlaubt daher im Wesentlichen die Unterscheidung zwischen fettem Abgas (λ < 1) bei Betrieb der Brennkraftmaschine mit Kraftstoffüberschuss und magerem Abgas (λ > 1) bei Betrieb mit Luftüberschuss und ermöglicht eine Regelung des Abgases auf ein Lambda von 1.

Voraussetzung für die stetige Lambdaregelung mit einer Zweipunktlambdasonde ist, dass zwischen der Sondenspannung der Zweipunktlambdasonde und Lambda ein eindeutiger Zusammenhang besteht. Dieser Zusammenhang muss über die gesamte Lebensdauer der Zweipunktlambdasonde vorliegen, da andernfalls die Genauigkeit der Regelung nicht ausreichend ist und unzulässig hohe Emissionen auftreten können. Aufgrund von Fertigungstoleranzen und von Alterungseffekten der Zweipunktlambdasonde ist diese Voraussetzung nicht erfüllt. Stattdessen kann die tatsächliche Sondenkennlinie durch mehrere überlagerte Effekte gegenüber der Referenzsondenkennlinie verschoben sein.

Daher werden Zweipunktlambdasonden vor Katalysator zumeist mit einer Zweipunktregelung verwendet. Diese hat den Nachteil, dass in Betriebsmodi, für die ein mageres oder fettes Luft-/Kraftstoffgemisch notwendig ist, beispielsweise zur Katalysatordiagnose oder zum Bauteileschutz, das Ziellambda nur vorgesteuert eingestellt, aber nicht geregelt werden kann.

Die DE 10 2012 211 687 A1 beschreibt ein Verfahren zur Erkennung eines Spannungsoffsets einer Spannungs-Lambda-Kennlinie.

Trotz der Vorteile der aus dem Stand der Technik bekannten Verfahren zur Erkennung eines Spannungsoffsets beinhalten diese noch Verbesserungspotential.

So ist in dem zuletzt genannten Stand der Technik ein Verfahren beschrieben, mit dem sich Verschiebungen der tatsächlichen Sondenkennlinie gegenüber der Referenzsondenkennlinie erkannt und kompensiert werden können. Damit wird eine stetige Lambdaregelung mit einer Zweipunktlambdasonde vor Katalysator möglich. Zur Erkennung von temperaturbedingten Kennlinienverschiebungen verwendet dieses Verfahren eine Änderung des Luft-/Kraftstoffgemischs ausgehend von einem zu überprüfenden Wertepaar auf der Referenz-Spannungs-Lambda-Kennlinie der Zweipunktlambdasonde hin zu Lambda = 1. Aus der Änderung der Zusammensetzung des Luft-/Kraftstoffgemischs bis zum Erreichen von Lambda = 1 wird auf den tatsächlichen Wert von Lambda vor der Änderung geschlossen. Diese Vorgehensweise setzt voraus, dass die Änderung mit einem klar definierten Profil erfolgt, wie beispielsweise rampenförmig mit einer klar definierten Steigung.

Diese Voraussetzung ist in der Regel nicht in allen Motorbetriebspunkten erfüllt. Insbesondere bei kurzen Einspritzzeiten ist die Einspritzventilkennlinie, die die Abhängigkeit der eingespritzten Kraftstoffmenge von der Einspritzzeit beschreibt, in der Regel wellig. Eine im Steuergerät hinterlegte Referenzeinspritzventilkennlinie berücksichtigt diese Welligkeit zwar, aber durch Bauteiltoleranzen kann es zu Abweichungen zwischen der realen Einspritzventilkennlinie und der Referenzeinspritzventilkennlinie kommen. Diese Abweichungen führen dazu, dass temperaturbedingte Kennlinienverschiebungen der Zweipunktlambdasonde in entsprechenden Motorbetriebspunkten nur ungenau bestimmt werden können. Diese Ungenauigkeit kann sich verstärkt bei Motoren mit Benzindirekteinspritzung und kleinem Hubraum bemerkbar machen, weil dort kurze Einspritzzeiten vergleichsweise häufig vorkommen.

Weiterer Stand der Technik ist in der US2011/040472 A1, der US2012/116654 A1, der EP1 088 978 A2, der US 2014/311459 und der FR2 877 400 A1 offenbart.

### Offenbarung der Erfindung

Es wir daher ein Verfahren zur Erkennung eines Spannungsoffsets zumindest in einem Bereich einer Spannungs-Lambda-Kennlinie vorgeschlagen, das den Bereich der Anwendbarkeit der obigen Verfahren erweitert und bei dem insbesondere Toleranzen der Einspritzventilkennlinie bei der Erkennung von Kennlinienverschiebungen einer Zweipunktlambdasonde berücksichtigt werden können.

Bei dem erfindungsgemäßen Verfahren zur Erkennung eines Spannungsoffsets zumindest in einem Bereich einer Spannungs-Lambda-Kennlinie einer in einem Abgaskanal einer Brennkraftmaschine angeordneten Zweipunktlambdasonde gegenüber einer Referenz-Spannungs-Lambda-Kennlinie der Zweipunktlambdasonde, ist die Zweipunktlambdasonde Teil einer Regelstrecke zur Einstellung eines der Brennkraftmaschine zugeführten Luft-/Kraftstoffgemisches, wobei eine Kennlinienabweichung der Spannungs-Lambda-Kennlinie zu der Referenz-Spannungs-Lambda-Kennlinie bei Lambda = 1 korrigiert ist, wobei, ausgehend von einem zu überprüfenden Wertepaar auf der Referenz-Spannungs-Lambda-Kennlinie mit einem zu überprüfenden Lambda und einer zu überprüfenden Spannung, eine Änderung der Zusammensetzung des der Brennkraftmaschine zugeführten Luft-/Kraftstoffgemischs hin zu Lambda = 1 erfolgt und wobei aus der Änderung der Zusammensetzung des Luft-/Kraftstoffgemischs bis zum Erreichen von Lambda = 1 auf den tatsächlichen Wert von Lambda geschlossen wird, wobei in einem ersten Verfahrensschritt eine Verzögerungszeit der Regelstrecke bestimmt wird, wobei in einem zweiten Verfahrensschritt, ausgehend von dem zu überprüfenden Wertepaar, die Änderung der Zusammensetzung des Luft-/Kraftstoffgemischs als rampenförmige Lambdaänderung hin zu Lambda = 1 erfolgt, wobei die Änderung der Zusammensetzung mit der Verzögerungszeit der Regelstrecke korrigiert wird, wobei der tatsächliche Wert von Lambda in dem Wertepaar aus der korrigierten Änderung der Zusammensetzung des Luft-/Kraftstoffgemischs bestimmt wird, wobei aus einer Abweichung des tatsächlichen Wertes von Lambda von dem zu überprüfenden Wert von Lambda ein Spannungsoffset der Spannungs-Lambda-Kennlinie erkannt wird, wobei der erste Verfahrensschritt und der zweite Verfahrensschritt durchgeführt werden, falls ein Schwellwert einer eine Einspritzzeit einer der Brennkraftmaschine zugeführten Einspritzmenge an Kraftstoff überschritten wird.

Der Schwellwert kann 2,0 ms und bevorzugt 2,5 ms sein. Der Schwellwert kann in Abhängigkeit von mindestens einem Betriebspunkt der Brennkraftmaschine veränderbar sein. Der Betriebspunkt kann beispielsweise ausgewählt sein aus der Gruppe bestehend aus: Absenkung eines Raildrucks der Brennkraftmaschine, Einfacheinspritzung, Zündwinkelverstellung und Abschaltung mindestens eines Zylinders. Zum Durchführen des Verfahrens kann abgewartet werden, bis basierend auf einem Betriebspunkt der Brennkraftmaschine der Schwellwert überschritten wird und/oder ein Betriebspunkt der Brennkraftmaschine derart verändert wird, dass der Schwellwert überschritten wird. Das Verfahren kann wiederholt durchgeführt werden. Das Verfahren kann durchgeführt werden, nachdem abgewartet wurde, bis basierend auf einem Betriebspunkt der Brennkraftmaschine der Schwellwert überschritten wurde und anschließend das Verfahren durchgeführt wird, nachdem ein Betriebspunkt der Brennkraftmaschine derart verändert wurde, dass der Schwellwert überschritten wurde. Das Verfahren kann durchgeführt werden, nachdem ein Betriebspunkt der Brennkraftmaschine derart verändert wurde, dass der Schwellwert überschritten wurde und anschließend das Verfahren durchgeführt wurde, nachdem abgewartet wurde, bis basierend auf einem Betriebspunkt der Brennkraftmaschine der Schwellwert überschritten wird. In dem ersten Verfahrensschritt kann, ausgehend von dem zu überprüfenden Wertepaar eine sprunghafte Änderung der Zusammensetzung des Luft-/Kraftstoffgemischs über Lambda = 1 hinaus durchgeführt werden und die Verzögerungszeit aus der zeitlichen Differenz zwischen der sprunghaften Änderung der Zusammensetzung des Luft-/Kraftstoffgemischs und dem Erreichen der Lambda = 1 entsprechenden Ausgangsspannung der Zweipunktlambdasonde bestimmt werden. In dem zweiten Verfahrensschritt kann ausgehend von dem zu überprüfenden Wertepaar eine Änderung der Zusammensetzung des Luft-/Kraftstoffgemischs über Lambda = 1 hinaus mit einer zweiten rampenförmigen Änderung der Zusammensetzung des Luft-/Kraftstoffgemischs zumindest im Bereich um Lambda = 1 durchgeführt werden und das tatsachliche Lambda in dem zu überprüfenden Wertepaar aus der Änderung der Zusammensetzung des Luft-/Kraftstoffgemischs bis zum Erreichen der Lambda = 1 entsprechenden Ausgangsspannung der Zweipunktlambdasonde abzüglich der Änderung der Zusammensetzung des Luft-/Kraftstoffgemischs während der Verzögerungszeit der Regelstrecke bestimmt werden. Ein erkannter Spannungsoffset der Spannungs-Lambda-Kennlinie kann mit dem tatsachlichen Wert von Lambda korrigiert werden und/oder in Abhängigkeit von dem erkannten Spannungsoffset kann auf eine oder mehrere Ursachen für den Spannungsoffset geschlossen werden und es können Maßnahmen zur Vermeidung oder Verringerung der Ursachen getroffen werden. In dem ersten Verfahrensschritt kann eine erste rampenförmige Änderung der Zusammensetzung des Luft-/Kraftstoffgemischs zur Bestimmung der Verzögerungszeit der Regelstrecke vorgesehen werden und die Steigung der zweiten rampenförmigen Änderung kann an den Betriebspunkt der Brennkraftmaschine angepasst werden und/oder in dem zweiten Verfahrensschritt kann die Steigung der zweiten rampenförmigen Änderung der Zusammensetzung des Luft-/Kraftstoffgemischs an den Betriebspunkt der Brennkraftmaschine angepasst werden. Die Zusammensetzung des Luft-/Kraftstoffgemischs bei dem zu überprüfenden Wertepaar kann für eine Stabilisierungsdauer des Ausgangssignals der Zweipunktlambdasonde konstant gehalten werden. Der Spannungsoffset kann für verschiedene Lambdabereiche, insbesondere für einen fetten und einen mageren Lambdabereich, erkannt werden. Die zu überprüfenden Wertepaare können so gewählt werden, dass ein vorgegebenes Soll-Lambda im zeitlichen Mittel eingehalten wird. Die Erkennung des Spannungsoffsets kann durch wiederholte Messungen bei demselben Wertepaar oder durch Messungen bei verschiedenen Wertepaaren plausibilisiert werden. Die Erkennung des Spannungsoffsets kann bei einer Schubabschaltung der Brennkraftmaschine plausibilisiert werden. Das zu überprüfende Wertepaar kann gezielt eingestellt werden und/oder die Erkennung des Spannungsoffsets kann bei einem im Betrieb der Brennkraftmaschine auftretenden Wertepaar erfolgen. Die Erkennung des Spannungsoffsets kann während eines für die Dauer der Erkennung konstanten Betriebspunkts der Brennkraftmaschine durchgeführt werden. Vor einer erneuten Erkennung des Spannungsoffsets kann die Korrektur des Spannungsoffsets aus einem vorhergehenden Betriebszyklus der Brennkraftmaschine verwendet werden.

Weiterhin wird ein Computerprogramm vorgeschlagen, welches eingerichtet ist, jeden Schritt des erfindungsgemäßen Verfahrens durchzuführen.

Es wird zudem ein elektronisches Speichermedium vorgeschlagen, auf welchem ein solches Computerprogramm gespeichert ist.

Schließlich wird ein elektronisches Steuergerät vorgeschlagen, welches besagtes elektronisches Speichermedium mit einem erfindungsgemäßen Computerprogramm zum Durchführen des erfindungsgemäßen Verfahrens umfasst.

Ein Grundgedanke der Erfindung ist eine Beschränkung der Erkennung von Kennlinienverschiebungen einer Zweipunktlambdasonde auf Motorbetriebspunkte, bei denen Toleranzen der Einspritzventilkennlinie vernachlässigbar sind, und/oder das aktive Herbeiführen von Einspritzzeiten, die für die Erkennung gut geeignet sind. Der Vorteil dieses Verfahrens ist, dass die Genauigkeit und/oder die Laufhäufigkeit der Erkennung von Kennlinienverschiebungen einer Zweipunktlambdasonde verbessert wird. Dies wiederum erhöht die Genauigkeit einer stetigen Lambdaregelung mit einer kostengünstigen Zweipunktlambdasonde.

Im Folgenden wird beispielhaft davon ausgegangen, dass kurze Einspritzzeiten die Erkennung von Kennlinienverschiebungen der Zweipunktlambdasonde negativ beeinflussen können. Die Erfindung ist sinngemäß allerdings auch auf andere ungünstige Einspritzzeitbereiche anwendbar. Die Erfindung sieht grundsätzlich zwei Arten von Verfahren vor, die jeweils einzeln oder in Kombination zum Einsatz kommen können.

Beim passiven Verfahren wird die Erkennung von Kennlinienverschiebungen einer Zweipunktlambdasonde auf Motorbetriebspunkte mit ausreichend langen Einspritzzeiten beschränkt. Insbesondere ist vorgesehen, die Erkennung von temperaturbedingten Kennlinienverschiebungen auf Motorbetriebspunkte zu beschränken, in denen die eingangs beschriebene Voraussetzung, dass die Änderung der Zusammensetzung des Luft-/Kraftstoffgemischs mit einem klar definierten Profil erfolgt, erfüllt ist. Diese Beschränkung erfolgt beispielsweise durch eine Einschaltbedingung, die verhindert, dass die Erkennung bei zu kurzen Einspritzzeiten aktiviert wird. Vorzugsweise wird ein Schwellwert für die Einspritzzeit ermittelt, unterhalb dessen die Welligkeit der Einspritzventilkennlinie keine ausreichend genaue Erkennung erwarten lässt. Ein typischer Wert hierfür ist 2,5 ms. Unterschreitet die Einspritzzeit diese Schwelle, wird die Erkennung nicht aktiviert. Es ist vorteilhaft, den Schwellwert abhängig von anderen Bedingungen, wie beispielsweise dem Motorbetriebspunkt, variabel zu gestalten.

Durch das passive Verfahren wird die Genauigkeit der Erkennung von Kennlinienverschiebungen einer Zweipunktlambdasonde verbessert. Gleichzeitig werden die Gelegenheiten für die Erkennung bei einem ungünstigen Fahrprofil, beispielsweise wenn zu selten ausreichend hohe Einspritzzeiten erreicht werden, verringert.

Um diesen Nachteil des passiven Verfahrens zu vermeiden, werden beim aktiven Verfahren gezielt längere Einspritzzeiten während der Erkennung von Kennlinienverschiebungen einer Zweipunktlambdasonde herbeigeführt, weil bei längeren Einspritzzeiten die Welligkeit der Einspritzventilkennlinie üblicherweise so gering ist, dass sie die Erkennung nicht negativ beeinflusst. Dazu ist vorgesehen, dass die Funktionalität zur Erkennung von Kennlinienverschiebungen aktiv eine Erhöhung der Einspritzzeiten vom Motorsteuerungssystem anfordert. Um andere Funktionalitäten im Motorsteuerungssystem möglichst wenig zu beeinflussen, erfolgt diese aktive Anforderung vorzugsweise nur dann, wenn Bedingungen vorliegen, unter denen die Einspritzzeit ausreichend weit erhöht werden kann und unter denen eine solche Erhöhung eine erfolgreiche Erkennung erwarten lasst. Beispiele für Möglichkeiten, die Einspritzzeit zu erhöhen sind die Absenkung des Raildrucks, eine Einfacheinspritzung statt einer Mehrfacheinspritzung, eine Zündwinkelverstellung, um einen geringeren Wirkungsgrad zu erreichen, oder die Abschaltung einzelner Zylinder. Die Erkennung von Kennlinienverschiebungen der Zweipunktlambdasonde erfolgt dann bei höheren Einspritzzeiten und damit genauer. Sobald die Erkennung beendet ist werden die Einspritzzeiten wieder reduziert.

Als weitere Alternative ist die Kombination beider Verfahren vorgesehen. Dabei kann zunächst das passive Verfahren zum Einsatz kommen. Dadurch wird sichergestellt, dass die Messungen zur Erkennung von Kennlinienverschiebungen nicht durch zu kurze Einspritzzeiten verfälscht werden. Falls mit dem passiven Verfahren längere Zeit keine Erkennung möglich ist, beispielsweise weil die Einspritzzeiten dauernd zu kurz sind, werden Betriebsbedingungen abgewartet, bei denen zwar die aktuelle Einspritzzeit zu kurz ist, aber eine aktive Einspritzzeit erfolgversprechend wäre. Sobald das der Fall ist, wird aktiv eine Erhöhung der Einspritzzeit angefordert, also auf das aktive Verfahren gewechselt und so eine genauere Messung bei höheren Einspritzzeiten ermöglicht. Im Anschluss an die Erkennung wird zurück auf das passive Verfahren gewechselt.

Da eine einzelne Messung für eine zuverlässige Erkennung und Kompensation von Kennlinienverschiebungen üblicherweise nicht ausreicht, wenn vorher noch gar keine Messung stattgefunden hat, beispielsweise direkt nach der Fahrzeugmontage oder nach einem Austausch der Lambdasonde, kann es in solchen Fällen vorteilhaft sein, zunächst das aktive Verfahren zu aktivieren, um schnell eine erste vertrauenswürdige Kompensation zu erlauben, und anschließend zum passiven Verfahren überzugehen.

### Kurze Beschreibung der Zeichnungen

Weitere optionale Einzelheiten und Merkmale der Erfindung ergeben sich aus der nachfolgenden Beschreibung bevorzugter Ausführungsbeispiele, welche in den Figuren schematisch dargestellt sind.

Es zeigen:
- Figur 1: eine Spannungs-Lambda-Kennlinie einer Zweipunktlambdasonde mit einem Spannungsoffset gegenüber einer Referenz-Spannungs-Lambda-Kennlinie und
- Figur 2: einen zeitlichen Lambdaverlauf zur Erkennung eines Spannungsoffsets.

### Ausführungsformen der Erfindung

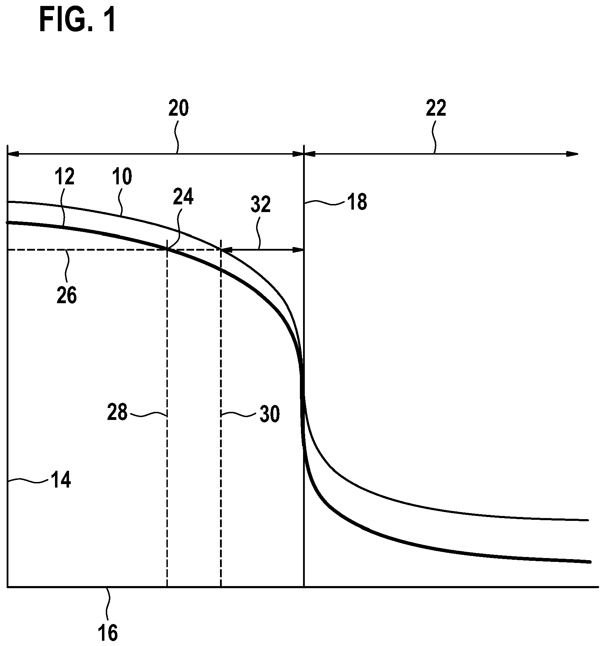

Fig. 1 zeigt eine Spannungs-Lambda-Kennlinie 10 einer Zweipunktlambdasonde mit einem Spannungsoffset gegenüber einer Referenz-Spannungs-Lambda-Kennlinie 12. Die Kennlinien 10, 12 sind gegenüber einer Achse Sondenspannung 14 und gegenüber einer Achse Lambda 16 aufgetragen.

Der dargestellte Lambdabereich ist durch eine Markierung 18 bei Lambda = 1 in einen fetten Lambdabereich 20 mit Lambda < 1 und in einen mageren Lambdabereich 22 mit Lambda > 1 aufgeteilt.

Ein zu überprüfendes Wertepaar 24 ist im Schnittpunkt von zwei gestrichelten Linien auf der Referenz-Spannungs-Lambda-Kennlinie 10 durch eine zu überprüfende Spannung 26 und ein zu überprüfendes Lambda 28 dargestellt. Ein tatsächlicher Wert von Lambda 30 ist für die zu überprüfende Spannung 26 auf der Spannungs-Lambda-Kennlinie 10 markiert. Eine Lambdaänderung 32 aufgrund einer Änderung des der Brennkraftmaschine zugeführten Luft-/Kraftstoffgemischs und somit von Lambda bis zum Erreichen von Lambda = 1 ist durch einen Doppelpfeil gezeigt.

Die Referenz-Spannungs-Lambda-Kennlinie 12 entspricht dem Verlauf des Ausgangssignals einer intakten, ungealterten Zweipunktlambdasonde im Abgaskanal einer Brennkraftmaschine bei einer Änderung der Abgaszusammensetzung. Sie weist bei Lambda = 1 ihre maximale Steigung auf. Der Sprung von einer hohen Ausgangsspannung zu einer niedrigen Ausgangsspannung findet in einem vergleichsweise kleinen Lambdafenster statt. Durch eine Alterung, durch Fertigungstoleranzen oder durch veränderte Betriebsbedingungen der Zweipunktlambdasonde kann sich deren Ausgangsspannung um einen Spannungsoffset gegenüber der Referenz-Spannungs-Lambda-Kennlinie 12 verschieben.

In dem vorliegenden Ausführungsbeispiel ist die Spannungs-Lambda-Kennlinie 10 um einen positiven Spannungsoffset gegenüber der Referenz-Spannungs-Lambda-Kennlinie 12 verschoben. Dabei ist der Spannungsoffset im mageren Lambdabereich 22 stärker ausgeprägt als im fetten Lambdabereich 20. Ein solcher Verlauf des Spannungsoffsets ist beispielsweise für zu heiß betriebene Zweipunktlambdasonden bekannt, die gleichzeitig einen konstanten Spannungsoffset über die gesamte Kennlinie aufweisen.

Die Verwendung einer Zweipunktlambdasonde für eine stetige Lambdaregelung vor Katalysator setzt voraus, dass einer bestimmten Sondenspannung eindeutig ein entsprechendes Abgaslambda zugeordnet werden kann. Das ist im Fall der Referenz-Spannungs-Lambda-Kennlinie 12 zutreffend. Liegt ein Spannungsoffset der tatsächlichen Spannungs-Lambda-Kennlinie 10 gegenüber der Referenz-Spannungs-Lambda-Kennlinie 12 vor, stimmt diese Zuordnung nicht mehr. Bei einem Spannungsoffset hin zu höheren Sondenspannungen, wie es in dem dargestellten Ausführungsbeispiel gezeigt ist, stellt sich eine vorgegebene Sondenspannung bei einem zu mageren Lambda ein. Bei einem Offset hin zu niedrigeren Sondenspannungen stellt sich dieselbe Sondenspannung bei einem zu fetten Lambda ein. Eine Lambdaregelung mit einer um einen positiven Spannungsoffset verschobenen Spannungs-Lambda-Kennlinie 10 führt demnach zu einem zu mageren Abgas, während eine um einen negativen Spannungsoffset verschobene Spannungs-Lambda-Kennlinie 10 zu einem zu fetten Abgas führt, was jeweils erhöhte Schadstoffemissionen der Brennkraftmaschine zur Folge hat.

Ein Spannungsoffset der Spannungs-Lambda-Kennlinie 10 kann dadurch erkannt werden, dass der tatsächliche Wert von Lambda 30 bei einer zu überprüfenden Spannung 26 der Zweipunktlambdasonde aus einer gezielt durchgeführten Änderung des der Brennkraftmaschine zugeführten Luft-/Kraftstoffverhältnisses bis zum Erreichen von Lambda = 1 bestimmt und mit dem zu überprüfenden Lambda 28 verglichen wird. Bei einer Abweichung kann der zu überprüfenden Spannung 26 der tatsächliche Wert von Lambda 30 zugeordnet und die Spannungs-Lambda-Kennlinie 10 dadurch korrigiert werden. Dabei wird die Spannungs-Lambda-Kennlinie 10 bevorzugt in einem größeren Bereich, beispielsweise in dem fetten Lambdabereich 20, korrigiert. Erfindungsgemäß ist es dabei vorgesehen, dass bei der Bestimmung des tatsachlichen Werts von Lambda 30 mögliche dynamische Effekte der Zweipunktlambdasonde berücksichtigt werden. Die dynamischen Effekte können in einem durch Alterung bedingten Dynamikverlust der Zweipunktlambdasonde begründet sein und ihr Einfluss ist vor der Bestimmung des tatsächlichen Werts von Lambda 30 zu ermitteln.

Alternativ oder zusätzlich zur Korrektur der Spannungs-Lambda-Kennlinie 10 kann aus dem Spannungsoffset beziehungsweise aus dem Verlauf des Spannungsoffsets auf die Ursache des Spannungsoffsets geschlossen und Maßnahmen zur Vermeidung oder Verringerung des Einflusses der Ursachen getroffen werden. In dem gezeigten Ausführungsbeispiel kann beispielsweise zunächst der konstante Spannungsoffset korrigiert werden und anschließend die Temperatur der Zweipunktlambdasonde reduziert werden, um die Spannungs-Lambda-Kennlinie 10 an die Referenz-Spannungs-Lambda-Kennlinie 12 anzupassen.

Voraussetzung für die beschriebene Erkennung eines Spannungsoffsets ist, dass eine eventuell bestehende Verschiebung des Lambda-1-Punkts sowie ein konstanter Offset der Spannungs-Lambda-Kennlinie 10 bereits zuvor nach bekannten Verfahren kompensiert wurden, so dass die Spannungs-Lambda-Kennlinie 10 im Lambda-1-Punkt mit der Referenz-Spannungs-Lambda-Kennlinie 12 übereinstimmt.

Die Korrektur und die Ursachenkompensation können in verschiedenen Bereichen der Spannungs-Lambda-Kennlinie 10 gesondert durchgeführt werden. Bei vollständiger Kompensation ist die Spannungs-Lambda-Kennlinie 10 mit der Referenz-Spannungs-Lambda-Kennlinie 12 deckungsgleich. Damit ist es möglich, auch bei einer gealterten Zweipunktlambdasonde einen eindeutigen Zusammenhang zwischen der Sondenspannung und Lambda zu erhalten. Damit kann auch mit einer im Vergleich zu einer Breitbandlambdasonde kostengünstigen Zweipunktlambdasonde in einem eingeschränkten Lambdabereich eine stetige Lambdaregelung vor Katalysator durchgeführt werden.

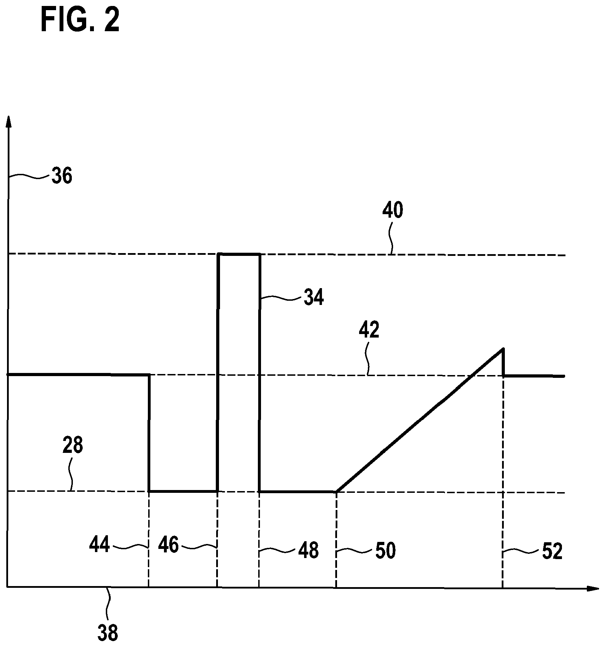

Fig. 2 zeigt in einem Ausführungsbeispiel einen zeitlichen Lambdaverlauf 34 zur Erkennung eines Spannungsoffsets bei einer verzögert reagierenden Zweipunktlambdasonde. Der Lambdaverlauf 34 ist gegenüber einer Achse Soll-Lambda 36 und einer Zeitachse 38 aufgetragen. Ein mageres Lambda 40, ein Soll-Lambda = 1 42 und das in Fig. 1 gezeigte zu überprüfende Lambda 28 sind durch gepunktete Linien gegenüber der Achse Soll-Lambda 36 markiert. Entsprechend sind ein erster Zeitpunkt 44, ein zweiter Zeitpunkt 46, ein dritter Zeitpunkt 48, ein vierter Zeitpunkt 50 und ein fünfter Zeitpunkt 52 gegenüber der Zeitachse 38 gekennzeichnet.

Das zu überprüfende Lambda 28 gehört zu einem in Fig. 1 gezeigten, zu überprüfenden Wertepaar 24 auf der Referenz-Spannungs-Lambda-Kennlinie 12 der Zweipunktlambdasonde. In dem Ausführungsbeispiel hat das zu überprüfende Lambda 28 beispielsweise einen Wert 0,95.

Die Zweipunktlambdasonde ist Teil einer Regelstrecke zur Einstellung eines der Brennkraftmaschine zugeführten Luft-/Kraftstoffgemischs. In einem ersten Verfahrensschritt zur Bestimmung einer Verzögerungszeit der Regelstrecke wird zu dem ersten Zeitpunkt 44 das der Brennkraftmaschine zugeführte Luft-/Kraftstoffgemisch so verändert, dass entsprechend der Referenz-Spannungs-Lambda-Kennlinie 10 das zu überprüfende Lambda 28 vorliegt. Nach einer vorgegebenen Stabilisierungszeit für die Sondenspannung erfolgt zu dem zweiten Zeitpunkt 46 eine sprungförmige Lambdaänderung über Lambda = 1 hinaus auf ein mageres Lambda 40 von beispielsweise 1,05.

Die sprungförmige Lambdaänderung von einem fetten zu dem mageren Lambda 40 bewirkt einen Sprung der Sondenspannung bei Lambda = 1. Dieser Sprung in der Sondenspannung erfolgt aufgrund von dynamischen Effekten verzögert. Die Verzögerungszeit zwischen dem Aufprägen der sprungförmigen Lambdaänderung und dem Sprung der Sondenspannung bei Lambda = 1 wird gemessen.

Nachdem die Verzögerungszeit der Regelstrecke bestimmt ist wird in einem zweiten Verfahrensschritt an dem dritten Zeitpunkt 48 wieder das zu überprüfende Lambda 28 eingestellt und für eine Stabilisierungszeit konstant gehalten. Zu dem vierten Zeitpunkt 50 wird die Ausgangsspannung der Zweipunktlambdasonde gemessen. Ausgehend von dem zu überprüfenden Lambda 28 erfolgt ab dem vierten Zeitpunkt 50 eine rampenförmige Lambdaänderung in Richtung magerer Lambdawerte. Die Steigung der rampenförmigen Lambdaänderung ist dabei vorzugsweise konstant und an den Betriebspunkt der Brennkraftmaschine angepasst.

Auch die rampenförmige Lambdaänderung von einem fetten zu einem mageren Lambda bewirkt einen Sprung der Sondenspannung bei Lambda = 1. Dieser Sprung erfolgt ebenfalls verzögert an dem fünften Zeitpunkt 52. Die Verzögerungszeit entspricht dabei der in dem ersten Verfahrensschritt gemessenen Verzögerungszeit.

Unmittelbar nach dem Sprung der Sondenspannung bei Lambda = 1 kann die rampenförmige Lambdaänderung abgebrochen werden und ein gewünschtes Soll-Lambda eingestellt werden.

Der tatsachliche Wert von Lambda 30 zum vierten Zeitpunkt 50 unmittelbar zu Beginn der rampenförmigen Lambdaänderung entspricht der Lambdaänderung, die notwendig war, bis die Sondenspannung zum fünften Zeitpunkt 52 bei Lambda = 1 gesprungen ist, abzüglich der Lambdaänderung, die während der im ersten Verfahrensschritt gemessenen Verzögerungszeit stattgefunden hat.

Die Abweichung zwischen dem zum vierten Zeitpunkt 50 ermittelten tatsächlichen Wert von Lambda 30 und dem bei der Ausgangsspannung zum vierten Zeitpunkt 50 gemäß der Referenz-Spannungs-Lambda-Kennlinie 12 erwarteten und zu überprüfenden Lambda 28 entspricht dem Kennlinienoffset an diesem Punkt der Spannungs-Lambda-Kennlinie 10.

Durch die Ermittlung des Einflusses von dynamischen Effekten unmittelbar vor der Messung des tatsächlichen Wertes von Lambda 30 wird die Lambdamessung gegenüber bisherigen Verfahren deutlich genauer. Der ermittelte Kennlinienoffset kann nachfolgend für eine Adaption der Sondenkennlinie oder für eine Kompensation von Ursachen, die zu dem Offset geführt haben, verwendet werden.

Die in dem ersten Verfahrensschritt und dem zweiten Verfahrensschritt beschriebenen sprungförmigen beziehungsweise rampenförmigen Lambdaänderungen sind besonders vorteilhaft für eine schnelle und genaue Erkennung eines Kennlinienoffsets. Prinzipiell sind aber auch andere Arten von Lambdaänderungen denkbar, die die Ermittlung des Einflusses von dynamischen Effekten sowie die Ermittlung des tatsächlichen Lambdas 30 bei einer bestimmten Sondenspannung erlauben.

Die Stabilisierungszeiten sowie die Rampensteigung können an den jeweiligen Betriebspunkt der Brennkraftmaschine angepasst werden, um die Erkennungsgenauigkeit zu erhöhen.

Ist ein Kennlinienoffset, wie in dem Ausführungsbeispiel in Fig. 1 gezeigt, in unterschiedlichen Bereichen der Spannungs-Lambda-Kennlinie 10 unterschiedlich ausgeprägt, kann das Verfahren für entsprechend mehrere zu überprüfende Wertepaare 24 angewendet und der Spannungsoffset abschnittsweise ermittelt werden.

Der ermittelte Spannungsoffset kann durch Wiederholung der Messung an demselben Punkt oder an anderen Punkten der Spannungs-Lambda-Kennlinie 10 plausibilisiert werden. Durch Mittelung oder Filterung des Messergebnisses kann die Erkennung verbessert werden.

Bei Brennkraftmaschinen, die einen Schubabgleich zulassen, kann der ermittelte Kennlinienoffset durch eine Messung bei einem Schubabgleich plausibilisiert werden.

Es ist vorteilhaft, einen Kennlinienoffset, der in einem vorhergehenden Betriebszyklus der Brennkraftmaschine ermittelt wurde, zu speichern und in den nächsten Betriebszyklus zu übernehmen. Es kann davon ausgegangen werden, dass sich ein Kennlinienoffset nur langsam ändert. Damit liegt im nächsten Betriebszyklus sofort eine korrigierte Spannungs-Lambda-Kennlinie 10 der Zweipunktlambdasonde vor.

Die beschriebenen Lambdaänderungen können zur Erkennung eines Spannungsoffsets aktiv eingestellt werden. Alternativ oder zusätzlich kann es vorgesehen sein, dass systembedingte aktive Lambdaänderungen, wie sie beispielsweise zur Katalysatordiagnose, zur Diagnose von Abgassonden oder in Phasen einer Zweipunktlambdaregelung vorgesehen sind, für die Erkennung genutzt werden.

Im Anschluss an eine Messung in dem fetten Lambdabereich 20 der Spannungs-Lambda-Kennlinie 10 kann eine entsprechende Messung in dem mageren Lambdabereich 22 erfolgen und umgekehrt. Dadurch bleibt im zeitlichen Mittel das Soll-Lambda erhalten und das Verfahren kann emissionsneutral durchgeführt werden.

Erfindungsgemäß wird nun das obige Verfahren durchgeführt, falls ein Schwellwert einer Eigenschaft einer der Brennkraftmaschine zugeführten Einspritzmenge an Kraftstoff überschritten oder unterschritten wird. Die Eigenschaft ist beispielsweise eine Einspritzzeit. Der Schwellwert kann dabei üblicherweise 2,0 ms und bevorzugt 2,5 ms sein. Der Schwellwert kann in Abhängigkeit von mindestens einem Betriebspunkt der Brennkraftmaschine veränderbar sein. Der Betriebspunkt kann beispielsweise ausgewählt sein aus der Gruppe bestehend aus: Absenkung eines Raildrucks der Brennkraftmaschine, Einfacheinspritzung, Zündwinkelverstellung und Abschaltung mindestens eines Zylinders. Zum Durchführen des Verfahrens und insbesondere des ersten Verfahrensschritts und des zweiten Verfahrensschritts kann abgewartet werden, bis basierend auf einem Betriebspunkt der Brennkraftmaschine der Schwellwert überschritten wird. Diese Vorgehensweise wird im Rahmen der vorliegenden Erfindung auch als passives Verfahren bezeichnet. Alternativ oder zusätzlich wird ein Betriebspunkt der Brennkraftmaschine derart verändert, dass der Schwellwert überschritten wird. Diese Vorgehensweise wird im Rahmen der vorliegenden Erfindung auch als aktives Verfahren bezeichnet. Das Verfahren kann wiederholt durchgeführt werden. Das Verfahren kann beispielsweise durchgeführt werden, nachdem abgewartet wurde, bis basierend auf einem Betriebspunkt der Brennkraftmaschine der Schwellwert überschritten wurde, und anschließend wird das Verfahren durchgeführt wird, nachdem ein Betriebspunkt der Brennkraftmaschine derart verändert wurde, dass der Schwellwert überschritten wird. Das Verfahren kann durchgeführt werden, nachdem ein Betriebspunkt der Brennkraftmaschine derart verändert wurde, dass der Schwellwert überschritten wurde und anschließend das Verfahren durchgeführt wurde, nachdem abgewartet wurde, bis basierend auf einem Betriebspunkt der Brennkraftmaschine der Schwellwert überschritten wird.

Bei dem oben beschriebenen passiven Verfahren wird die Erkennung von Kennlinienverschiebungen der Zweipunktlambdasonde auf Motorbetriebspunkte mit ausreichend langen Einspritzzeiten beschränkt. Mit anderen Worten wird abgewartet bis der Schwellwert der Einspritzzeit in Abhängigkeit von Motorbetriebspunkten überschritten wird. Insbesondere ist vorgesehen, die Erkennung von temperaturbedingten Kennlinienverschiebungen auf Motorbetriebspunkte zu beschränken, in denen die eingangs beschriebene Voraussetzung, dass die Änderung der Zusammensetzung des Luft-/Kraftstoffgemischs mit einem klar definierten Profil erfolgt, erfüllt ist. Diese Beschränkung erfolgt beispielsweise durch den Schwellwert, der als Einschaltbedingung dient und der verhindert, dass die Erkennung bei zu kurzen Einspritzzeiten aktiviert wird. Vorzugsweise wird ein Schwellwert für die Einspritzzeit verwendet, unterhalb dessen die Welligkeit der Einspritzventilkennlinie keine ausreichend genaue Erkennung erwarten lässt. Ein typischer Wert hierfür ist 2,5 ms. Unterschreitet die Einspritzzeit diesen Schwellwert, wird die Erkennung nicht aktiviert. Es ist vorteilhaft, den Schwellwert abhängig von anderen Bedingungen, wie beispielsweise dem Motorbetriebspunkt, variabel zu gestalten.

Bei dem oben beschriebenen aktiven Verfahren wird der Betriebspunkt verändert, um eine Überschreitung des Schwellwerts zu bewirken. Beispielsweise werden gezielt längere Einspritzzeiten während der Erkennung von Kennlinienverschiebungen einer Zweipunktlambdasonde herbeigeführt, weil bei längeren Einspritzzeiten die Welligkeit der Einspritzventilkennlinie üblicherweise so gering ist, dass sie die Erkennung nicht negativ beeinflusst. Dazu ist vorgesehen, dass die Funktionalität zur Erkennung von Kennlinienverschiebungen aktiv eine Erhöhung der Einspritzzeiten vom Motorsteuerungssystem anfordert. Um andere Funktionalitäten im Motorsteuerungssystem möglichst wenig zu beeinflussen, erfolgt diese aktive Anforderung vorzugsweise nur dann, wenn Bedingungen vorliegen, unter denen die Einspritzzeit ausreichend weit erhöht werden kann und unter denen eine solche Erhöhung eine erfolgreiche Erkennung erwarten lasst. Beispiele für Möglichkeiten, die Einspritzzeit zu erhöhen sind die Absenkung des Raildrucks, eine Einfacheinspritzung statt einer Mehrfacheinspritzung, eine Zündwinkelverstellung, um einen geringeren Wirkungsgrad zu erreichen, oder die Abschaltung einzelner Zylinder. Die Erkennung von Kennlinienverschiebungen der Zweipunktlambdasonde erfolgt dann bei höheren Einspritzzeiten und damit genauer. Sobald die Erkennung beendet ist werden die Einspritzzeiten wieder reduziert. Alternativ kann bei dem oben beschriebenen aktiven Verfahren der Betriebspunkt verändert werden, um eine Unterschreitung des Schwellwerts zu bewirken, wie beispielsweise eine Unterschreitung eines vorbestimmten Raildrucks oder Zündwinkels.

Als weitere Alternative ist die Kombination beider Verfahren vorgesehen. Dabei kann zunächst das passive Verfahren zum Einsatz kommen. Dadurch wird sichergestellt, dass die Messungen zur Erkennung von Kennlinienverschiebungen nicht durch zu kurze Einspritzzeiten verfälscht werden. Falls mit dem passiven Verfahren längere Zeit keine Erkennung möglich ist, beispielsweise weil die Einspritzzeiten dauernd zu kurz sind, werden Betriebsbedingungen abgewartet, bei denen zwar die aktuelle Einspritzzeit zu kurz ist, aber eine aktive Einspritzzeit erfolgversprechend wäre. Sobald das der Fall ist, wird aktiv eine Erhöhung der Einspritzzeit angefordert, also auf das aktive Verfahren gewechselt und so eine genauere Messung bei höheren Einspritzzeiten ermöglicht. Im Anschluss an die Erkennung wird zurück auf das passive Verfahren gewechselt.

Da eine einzelne Messung für eine zuverlässige Erkennung und Kompensation von Kennlinienverschiebungen üblicherweise nicht ausreicht, wenn vorher noch gar keine Messung stattgefunden hat, beispielsweise direkt nach der Fahrzeugmontage oder nach einem Austausch der Lambdasonde, kann es in solchen Fällen vorteilhaft sein, zunächst das aktive Verfahren zu aktivieren, um schnell eine erste vertrauenswürdige Kompensation zu erlauben, und anschließend zum passiven Verfahren überzugehen.

## Patentansprüche

1. Verfahren zur Erkennung eines Spannungsoffsets zumindest in einem Bereich einer Spannungs-Lambda-Kennlinie (10) einer in einem Abgaskanal einer Brennkraftmaschine angeordneten Zweipunktlambdasonde gegenüber einer Referenz-Spannungs-Lambda-Kennlinie (12) der Zweipunktlambdasonde, wobei die Zweipunktlambdasonde Teil einer Regelstrecke zur Einstellung eines der Brennkraftmaschine zugeführten Luft-/Kraftstoffgemisches ist, wobei eine Kennlinienabweichung der Spannungs-Lambda-Kennlinie (10) zu der Referenz-Spannungs-Lambda-Kennlinie (12) bei Lambda = 1 korrigiert ist, wobei, ausgehend von einem zu überprüfenden Wertepaar (24) auf der Referenz-Spannungs-Lambda-Kennlinie (12) mit einem zu überprüfenden Lambda (28) und einer zu überprüfenden Spannung (26), eine Änderung der Zusammensetzung des der Brennkraftmaschine zugeführten Luft-/Kraftstoffgemischs hin zu Lambda = 1 erfolgt und wobei aus der Änderung der Zusammensetzung des Luft-/Kraftstoffgemischs bis zum Erreichen von Lambda = 1 auf den tatsächlichen Wert von Lambda (30) geschlossen wird, wobei in einem ersten Verfahrensschritt eine Verzögerungszeit der Regelstrecke bestimmt wird, wobei in einem zweiten Verfahrensschritt, ausgehend von dem zu überprüfenden Wertepaar (24), die Änderung der Zusammensetzung des Luft-/Kraftstoffgemischs als rampenförmige Lambdaänderung hin zu Lambda = 1 erfolgt, wobei die Änderung der Zusammensetzung mit der Verzögerungszeit der Regelstrecke korrigiert wird, wobei der tatsächliche Wert von Lambda (30) in dem Wertepaar (24) aus der korrigierten Änderung der Zusammensetzung des Luft-/Kraftstoffgemischs bestimmt wird, wobei aus einer Abweichung des tatsächlichen Wertes von Lambda (30) von dem zu überprüfenden Wert von Lambda (28) ein Spannungsoffset der Spannungs-Lambda-Kennlinie (10) erkannt wird, **dadurch gekennzeichnet, dass** der erste Verfahrensschritt und der zweite Verfahrensschritt durchgeführt werden, falls ein Schwellwert einer Einspritzzeit an Kraftstoff überschritten wird.

2. Verfahren nach dem vorhergehenden Anspruch, wobei der Schwellwert 2,0 ms und bevorzugt 2,5 ms ist.

3. Verfahren nach einem der vorhergehenden Ansprüche, wobei der Schwellwert in Abhängigkeit von mindestens einem Betriebspunkt der Brennkraftmaschine veränderbar ist.

4. Verfahren nach dem vorhergehenden Anspruch, wobei der Betriebspunkt ausgewählt ist aus der Gruppe bestehend aus: Absenkung eines Raildrucks der Brennkraftmaschine, Einfacheinspritzung, Zündwinkelverstellung und Abschaltung mindestens eines Zylinders.

5. Verfahren nach einem der vorhergehenden Ansprüche, wobei zum Durchführen des Verfahrens abgewartet wird, bis basierend auf einem Betriebspunkt der Brennkraftmaschine der Schwellwert überschritten wird und/oder ein Betriebspunkt der Brennkraftmaschine derart verändert wird, dass der Schwellwert überschritten wird.

6. Verfahren nach dem vorhergehenden Anspruch, wobei das Verfahren wiederholt durchgeführt wird.

7. Verfahren nach Anspruch 6 oder 7, wobei das Verfahren durchgeführt wird, nachdem abgewartet wurde, bis basierend auf einem Betriebspunkt der Brennkraftmaschine der Schwellwert überschritten wird, und anschließend das Verfahren durchgeführt wird, nachdem ein Betriebspunkt der Brennkraftmaschine derart verändert wurde, dass der Schwellwert überschritten wird.

8. Verfahren nach Anspruch 6 oder 7, wobei das Verfahren durchgeführt wird, nachdem ein Betriebspunkt der Brennkraftmaschine derart verändert wurde, dass der Schwellwert überschritten wird, und anschließend das Verfahren durchgeführt wird, nachdem abgewartet wurde, bis basierend auf einem Betriebspunkt der Brennkraftmaschine der Schwellwert überschritten wird.

9. Computerprogramm, umfassend Befehle, die bei der Ausführung des Programms durch einen Computer diesen veranlassen, das Verfahren nach einem der vorhergehenden Ansprüche auszuführen.

10. Elektronisches Speichermedium, auf welchem ein Computerprogramm nach Anspruch 9 gespeichert ist.

11. Elektronisches Steuergerät, welches ein elektronisches Speichermedium nach Anspruch 10 umfasst.

## Claims

1. Method for identifying a voltage offset at least in a region of a voltage-lambda characteristic curve (10) of a two-point lambda probe arranged in an exhaust gas duct of an internal combustion engine relative to a reference voltage-lambda characteristic curve (12) of the two-point lambda probe, wherein the two-point lambda probe is part of a controlled system for setting an air/fuel mixture fed to the internal combustion engine, wherein a characteristic curve deviation of the voltage-lambda characteristic curve (10) with respect to the reference voltage-lambda characteristic curve (12) is corrected at lambda = 1, wherein, on the basis of a value pair (24) to be checked on the reference voltage-lambda characteristic curve (12) with a lambda (28) to be checked and a voltage (26) to be checked, a change in the composition of the air/fuel mixture fed to the internal combustion engine is carried out into lambda = 1 and wherein the actual value of lambda (30) is deduced from the change in the composition of the air/fuel mixture until lambda = 1 is attained, wherein, in a first method step, a delay time of the controlled system is determined, wherein, in a second method step, on the basis of the value pair (24) to be checked, the change in the composition of the air/fuel mixture is carried out as a ramped change in lambda until lambda = 1, wherein the change in the composition is corrected using the delay time of the controlled system, wherein the actual value of lambda (30) in the value pair (24) is determined from the corrected change in the composition of the air/fuel mixture, wherein a voltage offset of the voltage-lambda characteristic curve (10) is identified from a deviation of the actual value of lambda (30) from the value to be checked of lambda (28), **characterized in that** the first method step and the second method step are carried out if a threshold value of a fuel injection time is exceeded.

2. Method according to the preceding claim, wherein the threshold value is 2.0 ms and preferably 2.5 ms.

3. Method according to either of the preceding claims, wherein the threshold value is variable depending on at least one operating point of the internal combustion engine.

4. Method according to the preceding claim, wherein the operating point is selected from the group consisting of: reduction of a rail pressure of the internal combustion engine, single injection, ignition angle adjustment and shutdown of at least one cylinder.

5. Method according to any of the preceding claims, wherein carrying out the method involves waiting until the threshold value is exceeded on the basis of an operating point of the internal combustion engine and/or an operating point of the internal combustion engine is altered in such a way that the threshold value is exceeded.

6. Method according to the preceding claim, wherein the method is carried out repeatedly.

7. Method according to Claim 6 or 7, wherein the method is carried out after there has been a wait until the threshold valve is exceeded on the basis of an operating point of the internal combustion engine, and the method is subsequently carried out after an operating point of the internal combustion engine has been altered in such a way that the threshold value is exceeded.

8. Method according to Claim 6 or 7, wherein the method is carried out after an operating point of the internal combustion engine has been altered in such a way that the threshold value is exceeded, and the method is subsequently carried out after there has been a wait until the threshold value is exceeded on the basis of an operating point of the internal combustion engine.

9. Computer program, comprising instructions which, when the program is executed by a computer, cause the latter to carry out the method according to any of the preceding claims.

10. Electronic storage medium on which a computer program according to Claim 9 is stored.

11. Electronic control unit comprising an electronic storage medium according to Claim 10.

## Revendications

1. Procédé de détection d'un décalage de tension au moins dans une région d'une courbe caractéristique de tension lambda (10) d'une sonde lambda à deux points disposée dans un conduit d'échappement d'un moteur à combustion interne par rapport à une courbe caractéristique de tension lambda de référence (12) de la sonde lambda à deux points, la sonde lambda à deux points faisant partie d'une section de régulation destinée à réguler un mélange air/carburant amené au moteur à combustion interne, un décalage de la caractéristique de tension lambda (10) par rapport à la caractéristique de tension lambda de référence (12) étant corrigé pour lambda = 1, une modification de la composition du mélange air/carburant amené au moteur à combustion interne étant effectuée en direction de lambda = 1 à partir d'une paire de valeurs (24) à vérifier sur la caractéristique de tension lambda de référence (12) avec un lambda (28) à vérifier et une tension à vérifier (26) et la valeur réelle de lambda (30) étant déduite de la modification de la composition du mélange air/carburant jusqu'à atteindre lambda = 1, un temps de retard de la section de régulation étant déterminé dans une première étape de procédé, la modification de la composition du mélange air/carburant étant effectuée sous la forme d'une modification lambda en forme de rampe vers lambda = 1 dans une deuxième étape de procédé à partir de la paire de valeurs (24) à vérifier, la modification de la composition étant corrigée avec le temps de retard de la section de régulation, la valeur réelle de lambda (30) dans la paire de valeurs (24) étant déterminée à partir de la modification corrigée de la composition du mélange air/carburant, un décalage de tension de la caractéristique de tension lambda (10) étant détecté à partir d'un écart de la valeur réelle de lambda (30) par rapport à la valeur de lambda (28) à surveiller, **caractérisé en ce que** la première étape de procédé et la deuxième étape de procédé sont mises en oeuvre si une valeur seuil d'une durée d'injection de carburant est dépassée.

2. Procédé selon la revendication précédente, la valeur de seuil étant de 2,0 ms et de préférence de 2,5 ms.

3. Procédé selon l'une des revendications précédentes, la valeur de seuil pouvant être modifiée en fonction d'au moins un point de fonctionnement du moteur à combustion interne.

4. Procédé selon la revendication précédente, le point de fonctionnement étant choisi dans le groupe comprenant : l'abaissement de la pression de rail du moteur à combustion interne, l'injection simple, le réglage de l'angle d'allumage et l'arrêt d'au moins un cylindre.

5. Procédé selon l'une des revendications précédentes, pour mettre en oeuvre le procédé on attend jusqu'à ce que la valeur de seuil soit franchie vers le haut sur la base d'un point de fonctionnement du moteur à combustion interne et/ou qu'un point de fonctionnement du moteur à combustion interne soit modifié de telle sorte que la valeur de seuil soit franchie vers le haut.

6. Procédé selon la revendication précédente, le procédé étant mis en oeuvre à plusieurs reprises.

7. Procédé selon la revendication 6 ou 7, le procédé étant mis en oeuvre après avoir attendu que la valeur de seuil soit dépassée sur la base d'un point de fonctionnement du moteur à combustion interne, puis le procédé étant mis en oeuvre après qu'un point de fonctionnement du moteur à combustion interne a été modifié de telle sorte que la valeur de seuil soit franchie vers le haut.

8. Procédé selon la revendication 6 ou 7, le procédé étant mis en oeuvre après qu'un point de fonctionnement du moteur a été modifié de sorte que la valeur de seuil soit franchie vers le haut, puis le procédé étant mis en oeuvre après avoir attendu que la valeur de seuil soit franchie vers le haut sur la base d'un point de fonctionnement du moteur.

9. Programme informatique comprenant des instructions qui ordonnent, lors de l'exécution du programme par un ordinateur, de mettre en oeuvre le procédé selon l'une des revendications précédentes.

10. Support de mémorisation électronique sur lequel un programme informatique selon la revendication 9 est mémorisé.

11. Dispositif de commande électronique comprenant un support de mémorisation électronique selon la revendication 10.
